Europäisches Patentamt

European Patent Office

Office européen des brevets

(11) Veröffentlichungsnummer: **0 161 434 B1**

## (12) EUROPÄISCHE PATENTSCHRIFT

(45) Veröffentlichungstag der Patentschrift: 09.10.91

(51) Int. Cl.⁵: **H03K 17/945, H05K 9/00**

(21) Anmeldenummer: **85103437.1**

(22) Anmeldetag: **22.03.85**

(54) **Elektrisches, insbesondere elektronisches, berührungslos arbeitendes Schaltgerät.**

(30) Priorität: 17.04.84 DE 3414480

(43) Veröffentlichungstag der Anmeldung:
**21.11.85 Patentblatt 85/47**

(45) Bekanntmachung des Hinweises auf die
Patenterteilung:
**09.10.91 Patentblatt 91/41**

(84) Benannte Vertragsstaaten:
**AT BE CH DE FR GB IT LI LU NL SE**

(56) Entgegenhaltungen:
EP-A- 0 067 366    DE-A- 1 940 373
DE-A- 2 427 412    DE-A- 3 014 416
DE-A- 3 123 372    DE-A- 3 123 594

"Elektronischer Rasierer", Publication of
"Kabelwerke Reinshagen GmbH", Wuppertal
(DE), 1978

H. Koch: "Transistorsender", 1972, 3rd Edition, Franzis-Verlag G.E. Mayer KG, pages
140-142

"Schaller-Sensor, induktiv, Typ IN 2-12 G-P",
Editor: "Schaller Automation", industrielle
Automationstechnik KG, 6653 Blieskastel
(DE), dated 15 April 1977

"Schaller-Sensor, induktiv, Typ IN 1-8 G-P",
Editor: "Schaller Automation", industrielle
Automationstechnik KG, 6653 Blieskastel
(DE), dated: 3 February 1977

(73) Patentinhaber: **i f m electronic gmbh
Teichstrasse 4
W-4300 Essen 1(DE)**

(72) Erfinder: **Buck, Robert, Ing.(grad).
Vogelherdbogen 67
W-7992 Tettnang 1(DE)**
Erfinder: **Lichte, Norbert
Säntisweg 14
W-7981 Schlier 1(DE)**

(74) Vertreter: **Gesthuysen, Hans Dieter, Dipl.-Ing.
et al
Patentanwälte Gesthuysen + von Rohr
Huyssenallee 15 Postfach 10 13 33
W-4300 Essen 1(DE)**

## Beschreibung

Die Erfindung betrifft ein elektrisches, insbesondere elektronisches, berührungslos arbeitendes Schaltgerät, mit einem Gehäuse, mindestens einem in dem Gehäuse vorgesehenen Bauelementeträger, einem im wesentlichen flächenhaften Hilfsträger und zumindest teilweise auf dem Bauelementeträger angeordneten und zu einer elektrischen Schaltung miteinander verbundenen elektrischen und/oder elektronischen Bauelementen, wobei der Bauelementeträger aus einem flexiblen, elektrisch isolierenden Material besteht und Leiterbahnen zur elektrischen Verbindung der Bauelemente miteinander aufweist und der Hilfsträger auf beiden Seiten flächig mit Teilen des Bauelementeträgers verbunden ist.

Elektrische Schaltgeräte der in Rede stehenden Art sind in einer großen Vielzahl von Ausführungsformen bekannt. Insbesondere sind solche Schaltgeräte als induktive oder kapazitive Annäherungsschalter bekannt, wobei dann ein von außen beeinflußbarer Oszillator, ggf. ein Schaltverstärker, ein von dem Oszillator - ggf. über den Schaltverstärker - steuerbarer elektronischer Schalter, z. B. ein Transistor, ein Thyristor oder ein Triac, und ggf. eine Speiseschaltung zur Erzeugung der Speisespannung für den Oszillator und ggf. für den Schaltverstärker verwirklicht sind.

Elektronische, berührungslos arbeitende Schaltgeräte sind anfangs mit einer Reihe von elektrischen Problemen behaftet gewesen, - gemessen an elektrischen, mechanisch betätigten Schaltgeräten, nämlich u. a. mit den Problemen "Erzeugung einer Speisespannung für den Oszillator und ggf. für den Schaltverstärker", "Ausbildung des Oszillators", "Ausbildung des Schaltverstärkers", "Einschaltimpulsverhinderung", "Kurzschlußfestigkeit".

Neben den in der Vergangenheit bei Schaltgeräten der in Rede stehenden Art im wesentlichen schon gelösten elektrischen Problemen gab es auch eine Reihe von mechanischen Problemen, die gleichfalls im wesentlichen schon gelöst worden sind. Ein solches Problem bestand darin, auf möglichst geringem Raum die insgesamt erforderlichen Bauelemente - bzw. bei vorgegebenem Raum möglichst viele Bauelemente - fertigungstechnisch optimal unterzubringen.

Bei dem bekannten elektrischen Schaltgerät, von dem die Erfindung ausgeht (vgl. die DE-PS 31 23 372), ist bereits eine relativ hohe "Packungsdichte" erzielt, und zwar dadurch, daß zusätzlich zu dem Bauelementeträger ein - im wesentlichen flächenhafter - Hilfsträger vorgesehen und der Bauelementeträger auf beiden Seiten des Hilfsträgers angeordnet ist. Hier werden zwei Ebenen für die Bauelemente realisiert, so daß der Raum im Gehäuse besser ausgenutzt ist.

Im übrigen sind elektronische, berührungslos arbeitende Schaltgeräte bekannt (vgl. den "SCHALLER-SENSOR", inductiv, Typ IN 2 - 12 G - P bzw. IN 1 - 8 G - P, und die DE-OS 30 14 416), zu denen ein Gehäuse, ein in dem Gehäuse vorgesehener Bauelementeträger und zumindest teilweise auf dem Bauelementeträger angeordnete und zu einer elektrischen Schaltung miteinander verbundene elektrische und/oder elektronische Bauelemente gehören. Der Bauelementeträger besteht aus einem flexiblen, elektrisch isolierenden Material, weist Leiterbahnen zur elektrischen Verbindung der Bauelemente miteinander und einen keine Bauelemente tragenden Verlängerungsstreifen mit einer darauf angeordneten, im wesentlichen durchgehenden, elektrisch leitenden Beschichtung auf. Der Verlängerungsstreifen ist als Abschirmung um den Bauelemente tragenden Teil des Bauelementeträgers gerollt bzw. gefaltet.

Im übrigen ist ein elektronischer Schaltungsaufbau bekannt (vgl. die DE-OS 19 40 373), bei dem der Bauelementeträger gefaltet bzw. gerollt ist, so daß für die Unterbringung der Bauelemente verschiedene Ebenen realisiert sind. Dadurch wird der vorhandene Raum optimal ausgenutzt und ebenfalls eine relativ hohe "Packungsdichte" erzielt.

Während bei dem zuletzt erläuterten bekannten elektronischen Schaltungsaufbau die Leiterbahnen auf der von den Bauelementen abgewandten Seite des Bauelementeträgers angeordnet sind, sind bei dem bekannten elektrischen Schaltgerät, von dem die Erfindung ausgeht, die Leiterbahnen auf der den Bauelementen zugewandten Seite des Bauelementeträgers angeordnet. Das hat den Vorteil, daß durch den Bauelementeträger selbst auf der von den Bauelementen abgewandten Seite eine Isolierschicht gebildet ist, wohingegen bei dem erläuterten bekannten elektronischen Schaltungsaufbau zu diesem Zweck noch eine gesonderte Isolierschicht aufgebracht werden muß.

Schließlich ist es für sich bekannt (vgl. die DE-OS 24 27 412, die Literaturstelle "Transistorsender" von Harry Koch, 3. Auflage, 1972, Francis-Verlag G. Emil Mayer KG und das Prospektblatt "Elektronischer Rasierer" der Firma Kabelwerke Reinshagen GmbH), Bauelementeträger, auch solche, die aus einem flexiblen, elektrisch isolierenden Material bestehen und Leiterbahnen zur elektrischen Verbindung der Bauelemente miteinander aufweisen, auf der den Bauelementen abgewandten Seite mit einer im wesentlichen durchgehenden, elektrisch leitenden, gegen die Leiterbahnen elektrisch isolierten Beschichtung zu versehen.

Ausgehend von dem zuvor erläuterten Stand der Technik liegt der Erfindung nun die Aufgabe zugrunde, bei einem Schaltgerät der in Rede stehenden Art die "Packungsdichte" noch zu erhöhen und das Problem der elektrischen Abschirmung gegen Störfelder elegant zu lösen.

Das erfindungsgemäße elektrische Schaltgerät, bei dem die zuvor aufgezeigte Aufgabe gelöst ist, ist nach einer ersten Lehre der Erfindung dadurch gekennzeichnet, daß die nicht mit dem Hilfsträger verbundenen Teile des Bauelementeträgers auf den Hilfsträger zurückgefaltet sind und der Bauelementeträger auf der den Bauelementen abgewandten Seite mit einer im wesentlichen durchgehenden, elektrisch leitenden, gegen die Leiterbahnen elektrisch isolierten Beschichtung versehen ist.

Sind die Leiterbahnen bei dem erfindungsgemäßen elektrischen Schaltgerät auf der den Bauelementen zugewandten Seite des Bauelementeträgers angeordnet, so gibt es hinsichtlich der Isolierung der elektrisch leitenden Beschichtung gegenüber den Leiterbahnen kein Problem, da der Bauelementeträger als Isolierung wirkt. Sind allerdings die Leiterbahnen auf der von den Bauelementen abgewandten Seite des Bauelementeträgers angeordnet, so muß zwischen den Leiterbahnen und der elektrischen Beschichtung eine Isolierschicht vorgesehen werden.

Die zuvor erläuterte Aufgabe ist nach einer zweiten Lehre der Erfindung dadurch gelöst, daß die nicht mit dem Hilfsträger verbundenen Teile des Bauelementeträgers auf den Hilfsträger zurückgefaltet sind, der Bauelementeträger einen keine Bauelemente tragenden Verlängerungsstreifen mit einer darauf angeordneten, im wesentlichen durchgehenden, elektrisch leitenden Beschichtung aufweist und der Verlängerungsstreifen zumindest teilweise als Abschirmung um den Bauelemente tragenden Teil des Bauelementeträgers gefaltet ist.

Bei dem zuvor beschriebenen erfindungsgemäßen elektrischen Schaltgerät kann die Beschichtung auf der von den Bauelementen abgewandten Seite des Verlängerungsstreifens angeordnet sein. Diese Lösung empfiehlt sich insbesondere dann, wenn auch die Leiterbahnen auf der von den Bauelementen abgewandten Seite des Bauelementeträgers angeordnet sind, - da dann die elektrisch leitende Beschichtung des Verlängerungsstreifens in einem Zug mit den Leiterbahnen aufgebracht werden kann.

Die zuvor erläuterten Überlegungen führen dazu, daß bei auf der den Bauelementen zugewandten Seite des Bauelementeträgers angeordneten Leiterbahnen auch die elektrische Beschichtung des Verlängerungsstreifens des Bauelementeträgers auf der den Bauelementen zugewandten Seite angeordnet ist. Das ist fertigungstechnisch besonders zweckmäßig, bedeutet aber natürlich nicht, daß in diesem Fall nicht die Beschichtung auch auf der von den Bauelementen abgewandten Seite des Verlängerungsstreifens angeordnet sein könnte.

Die letztgenannte Lösung könnte sogar dann vorzuziehen sein, wenn andernfalls durch die elektrisch leitende Beschichtung des Verlängerungsstreifens die Gefahr von Kurzschlüssen zwischen den Bauelementen bestünde.

Erfindungsgemäß ist erkannt worden, daß die mehrfach gefaltete Anordnung des Bauelementeträgers zu einer besonders hohen "Packungsdichte" führt und eine gute Voraussetzung dafür bietet, auf elegante Weise eine elektrische Abschirmung zu realisiseren.

Bei Vorhandensein eines flexiblen gefalteten Bauelementeträgers bzw. eines Bauelementeträgers mit einem so gefalteten Verlängerungsstreifen ergibt sich die Möglichkeit, auf der von den Bauelementen abgewandten Seite des Bauelementeträgers bzw. eines streifenartigen Teils des Bauelementeträgers eine Leuchtdiode anzuordnen, die dann sehr leicht durch eine entsprechend angeordnete Öffnung im Gehäuse gesehen werden kann.

Im folgenden wird die Erfindung anhand einer lediglich Ausführungsbeispiele darstellenden Zeichen näher erläutert; es zeigt

Fig. 1 schematisch, eine bevorzugte Ausführungsform eines erfindungsgemäßen elektronischen, berührungslos arbeitenden Schaltgerätes, nämlich eines induktiven Annäherungsschalters, teilweise aufgeschnitten,

Fig. 2 einen Schnitt durch das elektronische Schaltgerät nach Fig. 1 längs der Linie II - II,

Fig. 3 einen Schnitt durch das elektronische Schaltgerät nach Fig. 1 längs der Linie II - II, das elektronische Schaltgerät jedoch mit einem etwas andersartigen Bauelementeträger bestückt, und

Fig. 4 den Bauelementeträger des Schaltgerätes aus Fig. 3, aus dem Gehäuse des Schaltgerätes herausgenommen.

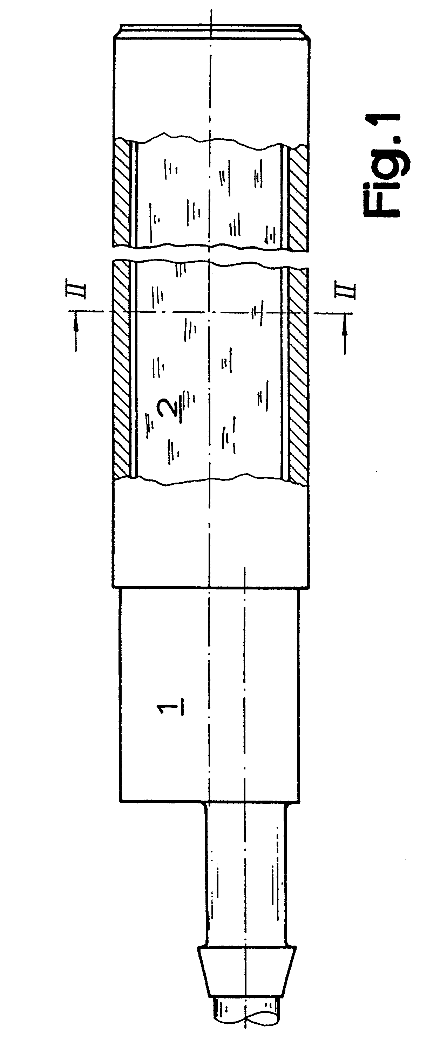

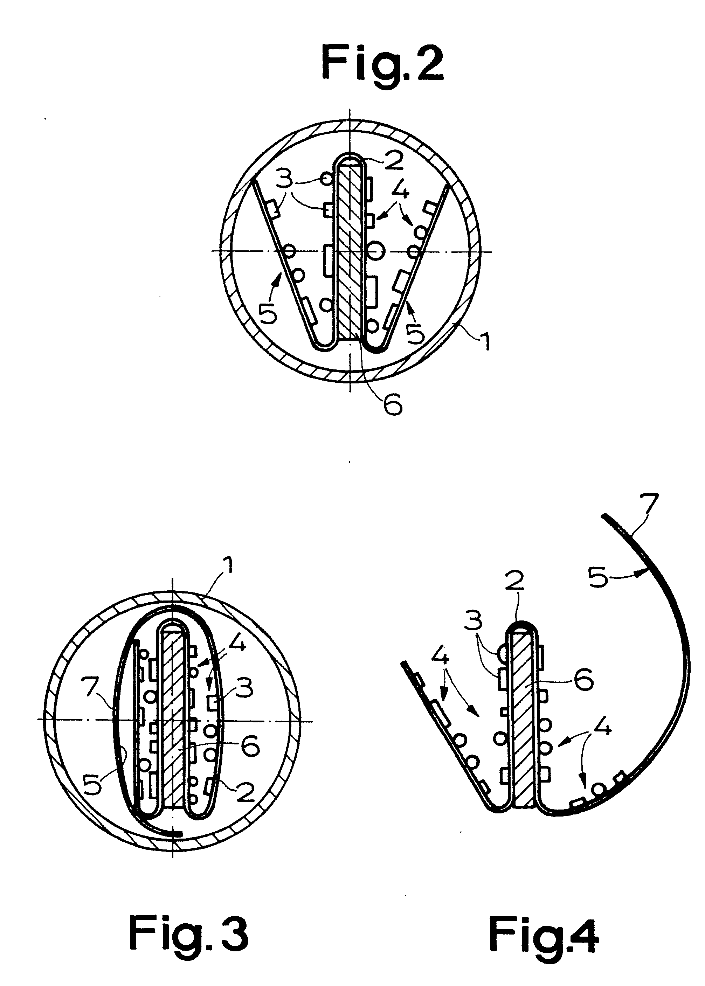

Das in Fig. 1 dargestellte elektronische, berührungslos arbeitende Schaltgerät weist ein Gehäuse 1 und einen in dem Gehäuse 1 vorgesehenen Bauelementträger 2 auf. Fig. 2 läßt erkennen, daß auf dem Bauelementeträger 2 elektrische bzw. elektronische Bauelemente 3 angeordnet und zu einer elektrischen Schaltung miteinander verbunden sind. Der Bauelementeträger 2 besteht aus flexiblem, elektrisch isolierendem Material und weist im einzelnen nicht dargestellte Leiterbahnen 4 zur elektrischen Verbindung der Bauelemente 3 auf. Deutlich erkennbar ist in Fig. 2, daß der Bauelementeträger 2 in montiertem Zustand des Schaltgerätes mehrfach gefaltet ist, so daß eine besonders hohe "Packungsdichte" erzielt ist.

In Fig. 2 ist angedeutet, daß der Bauelementeträger 2 auf der von den Bauelementen 3 abgewandten Seite mit einer im wesentlichen durchgehenden, elektrisch leitenden und gegen die Leiterbahnen 4 elektrisch isolierten Beschichtung 5 versehen ist; bei der elektrisch leitenden Beschichtung 5 kann es sich um eine übliche Kupferschicht od. dgl. handeln. Da die Leiterbahnen 4 im dargestellten Ausführungsbeispiel auf der den Bauelementen 3 zugewandten Seite des Bauelementeträgers 2 angeordnet sind, dient der Bauelementträger 2 selbst als elektrische Isolierung der Beschichtung 5 gegenüber den Leiterbahnen 4. Die elektrisch leitende Beschichtung 5 dient als Abschirmung der von den Bauelementen 3 gebildeten elektrischen Schaltung gegen Störfelder.

Fig. 2 läßt im übrigen weiter erkennen, daß zusätzlich zu dem Bauelementeträger 2 ein im wesentlichen flächenhafter Hilfsträger 6 vorgesehen ist. Der Hilfsträger 6 ist auf beiden Seiten flächig mit Teilen des Bauelementeträgers 2 verbunden. Die nicht mit dem Hilfsträger 6 verbundenen Teile des Bauelementeträgers 2 sind auf den Hilfsträger 6 zurück gefaltet. Damit sind die Bauelemente 3 gewissermaßen in vier Ebenen angeordnet, so daß eine besonders hohe "Packungsdichte" erzielt wird. Gleichzeitig ist die die Abschirmung gegen Störfelder darstellende elektrisch leitende Beschichtung 5 automatisch auf der Außenseite der elektrischen Schaltung angeordnet.

Bei dem in Fig. 3 dargestellten weiteren Ausführungsbeispiel eines erfindungsgemäßen elektrischen Schaltgerät wird ein etwas andersartiger Bauelementeträger 2 verwendet. Dieser Bauelementeträger 2 weist nämlich einen keine Bauelemente tragenden Verlängerungsstreifen 7 auf. Der Verlängerungsstreifen 7 weist die im wesentlichen durchgehende, elektrisch leitende Beschichtung 5 auf und ist als Abschirmung teilweise um den Bauelemente 3 tragenden Teil des Bauelementeträgers 2 faltbar. Im dargestellten Ausführungsbeispiel sind die Leiterbahnen 4 auf der den Bauelementen 3 zugewandten Seite des Bauelementeträgers 2 angeordnet und ist auch die Beschichtung 5 auf der den Bauelementen 3 zugewandten Seite des Verlängerungsstreifens 7 angeordnet. Das ist herstellungstechnisch besonders zweckmäßig. Auch hier ist ein Hilfsträger 6 vorgesehen, wobei aber natürlich der Verlängerungsstreifen 7 des Bauelementeträgers 2 nicht mit dem Hilfsträger 6 verbunden ist. Fig. 4 zeigt den im Schaltgerät gemäß Fig. 3 eingesetzten Bauelementeträger 2 außerhalb des Gehäuses 1. Man kann deutlich erkennen, daß durch die Elastizität des Bauelementeträgers 2 ein teilweises Ausfalten stattfindet.

## Patentansprüche

1. Elektrisches, inbesondere elektronisches, berührungslos arbeitendes Schaltgerät, mit einem Gehäuse (1), mindestens einem in dem Gehäuse vorgesehenen Bauelementeträger (2), einem im wesentlichen flächenhaften Hilfsträger (6) und zumindest teilweise auf dem Bauelementeträger angeordneten und zu einer elektrischen Schaltung miteinander verbundenen elektrischen und/oder elektronischen Bauelementen (3), wobei der Bauelementeträger aus einem flexiblen, elektrisch isolierenden Material besteht und Leiterbahnen (4) zur elektrischen Verbindung der Bauelemente miteinander aufweist und der Hilfsträger auf beiden Seiten flächig mit Teilen des Bauelementeträgers verbunden ist, **dadurch gekennzeichnet,** daß die nicht mit dem Hilfsträger (6) verbundenen Teile des Bauelementeträgers (2) auf den Hilfsträger (6) zurückgefaltet sind und der Bauelementeträger (2) auf der den Bauelementen (3) abgewandten Seite mit einer im wesentlichen durchgehenden, elektrisch leitenden, gegen die Leiterbahnen (4) elektrisch isolierten Beschichtung (5) versehen ist.

2. Elektrisches Schaltgerät nach Anspruch 1, dadurch gekennzeichnet, daß die Leiterbahnen (4) auf der den Bauelementen (3) zugewandten Seite des Bauelementeträgers (2) angeordnet sind.

3. Elektrisches, insbesondere elektronisches, berührungslos arbeitendes Schaltgerät, mit einem Gehäuse (1), mindestens einem in dem Gehäuse vorgesehenen Bauelementeträger (2), einem im wesentlichen flächenhaften Hilfsträger (6) und zumindest teilweise auf dem Bauelementeträger angeordneten und zu einer elektrischen Schaltung miteinander verbundenen elektrischen und/oder elektronischen Bauelementen (3), wobei der Bauelementeträger aus einem flexiblen, elektrisch isolierenden Material besteht und Leiterbahnen (4) zur elektrischen Verbindung der Bauelemente miteinander aufweist und der Hilfsträger auf beiden Seiten flächig mit Teilen des Bauelementeträgers verbunden ist, **dadurch gekennzeichnet,** daß die nicht mit dem Hilfsträger (6) verbundenen Teile des Bauelementeträgers (2) auf den Hilfsträger (6) zurückgefaltet sind, der Bauelementeträger (2) einen keine Bauelemente tragenden Verlängerungsstreifen (7) mit einer darauf angeordneten, im wesentlichen durchgehenden, elektrisch leitenden Beschichtung (5) aufweist und der Verlängerungsstreifen (7) zumindest teilweise als Abschirmung um den Bauelemente (3) tragenden Teil des Bauelementeträgers (2) gefaltet ist.

4. Elektrisches Schaltgerät nach Anspruch 3, dadurch gekennzeichnet, daß die Beschichtung auf der von den Bauelementen abgewandten Seite des Verlängerungsstreifens des Bauelementeträgers angeordnet ist.

5. Elektrisches Schaltgerät nach Anspruch 3, dadurch gekennzeichnet, daß die Beschichtung (5) auf der den Bauelementen (3) zugewandten Seite des Verlängerungsstreifens (7) des Bauelementeträgers (2) angeordnet ist.

6. Elektrisches Schaltgerät nach einem der Ansprüche 1 bis 5, dadurch gekennzeichnet, daß auf der von den Bauelementen abgewandten Seite des Bauelementeträgers bzw. eines streifenartigen Teils des Bauelementeträgers eine Leuchtdiode angeordnet ist.

## Claims

1. Electrical or electronic contactless switch comprising a housing (1), at least one carrier (2) received in said housing (1), a substantially flat auxiliary carrier (6) and electrical and/or electronic components (3), said components (3) being partly arranged on said carrier (2) and being inter-connected to form an electrical mounting, said carrier (2) consisting of a flexible, electrically non-conducting material and having conductive paths (4) for electrical connection of said components (3) to one another and said auxiliary carrier (6) being on both sides connected with and covered by parts of said carrier (2), **characterized in that** the parts of said carrier (2) which are not connected with the auxiliary carrier (6) are folded back towards said auxiliary carrier (6) and that an electrically conductive layer (5) is extending substantially continuously on the surface of ·said carrier (2) opposite said component side, said layer (5) being insulated from said conductive paths (4).

2. Contactless switch according to claim 1, characterized in that said conductive paths (4) are provided on said component side of said carrier (2).

3. Electrical or electronic contactless switch comprising a housing (1), at least one carrier (2) received in said housing (1), a substantially flat auxiliary carrier and electrical and/or electronic components (3), said components (3) being partly arranged on said carrier (2) and being inter-connected to form an electrical mounting, said carrier (2) consisting of a flexible, electrically non-conducting material and having conductive paths (4) for electrical connection of said components (3) to one another and said auxiliary carrier (6) being on both sides connected with and covered by parts of said carrier (2), **characterized in that** the parts of said carrier (2), which are not connected with said auxiliary carrier (6) are folded back towards said auxiliary carrier (6), said carrier (2) having an extension (7) free from said components (3), said extension (7) being continuously coated by an electrically conductive layer (5) and at least a portion of said extension (7) being folded to form an electrical shield around the part of the carrier (2) carrying said components (3).

4. Contactless switch according to claim 3, characterized in that said layer (5) is arranged on the side of the extension (7) of said carrier (2) being opposite of said components (3).

5. Contactless switch according to claim 3, characterized in that said layer (5) is provided on said component side of said extension (7) of said carrier (2).

6. Contactless switch according to one of the claims 1 to 5, characterized in that said carrier (2) or said extension (7) of said carrier (2) is carrying a light-emitting diode on its side opposite of that carrying the components (3).

## Revendications

1. Dispositif de commutation électrique et, en particulier, électronique fonctionnant sans contact, comportant un boîtier (1) au moins un support d'éléments constructifs (2) disposé dans le boîtier (1), un support auxiliaire (6) de forme essentiellement plate et des éléments constructifs (3) électriques et/on électroniques disposés, au moins partiellement, sur le support d'éléments constructifs (2) et reliés les uns aux autres pour former un circuit électrique, le support d'éléments constructifs (2) étant réalisé en un matériau flexible, électriquement isolant et présentant des bandes conductrices (4) assurant la liaison électrique des éléments constructifs (3) entre eux et le support d'éléments constructifs (2) étant disposé de part et d'autre du support auxiliaire (6) et couvrant partiellement le support auxiliaire (6), **caractérisé en ce que** les parties du support d'éléments constructifs (2), qui ne sont pas disposées sur le support auxiliaire (6) sont repliées en direction du support auxiliaire (6) et que le support d'éléments constructifs (2) est couvert sur ses faces opposées aux éléments constructifs (3) avec une couche (5) essentiellement continuante, conductive et électricement isolée vers les bandes conductrices (4).

2. Dispositif de commutation életrique selon la revendication 1, charactérisé en ce que les bandes conductrices (4) sont disposées sur les faces du support d'éléments constructifs (2) fournées vers les éléments constructifs (3).

3. Dispositif de commutation électrique et, en particulier, électronique fonctionnant sans contact, comportant un boîtier (1), au moins un support d'éléments constructifs (2) disposé dans le boîtier (1), un support auxiliaire (6) de forme essentiellement plate et des éléments constructifs (3) électriques et/on électroniques disposés, au moins partiellement, sur le support d'éléments constructifs (2) et reliés les uns aux autres pour former un circuit électrique, le support d'éléments constructifs (2) étant réalisé en un matériau flexible, électriquement isolant et présentant des bandes conductrices (4) assurant la liaison électrique des éléments constructifs (3) entre eux et le support d'éléments constructifs (2) étant disposé de part et d'autre du support auxiliaire (6) et couvrant partiellement le support auxiliaire (6), **charactérisé en ce que** les parties du support d'éléments constructifs (2), qui ne sont pas disposées sur le support auxiliaire (6) sont repliées en direction du support auxiliaire (6), que le support d'éléments constructifs (2) présente une élongation (7) non portant des éléments constructifs (3) et couverte avec une couche (5) essentiellement continuante et conductive et que l'élongation (7) est pour protection au moins partiellement reliée autour de la partie du support d'éléments constructifs (2) portant les éléments constructifs (3).

4. Dispositif de commutation électrique selon la revendication 3, charactérisé ce que la couche (5) est disposée sur les faces d'élongation (7) du support d'éléments constructifs (2) opposées aux éléments constructifs (3).

5. Dispositif de commutation électrique selon la revendication 3, charactérisé en ce que la couche (5) est disposée sur les faces d'élongation (7) du support d'éléments constructifs (2) tournées vers de les éléments constructifs (3).

6. Dispositif de commutation électrique selon une des revendication 1 à 5, charactérisé en ce que une diode lumineuse est disposée aux faces du support d'éléments constructifs (2) ou d'élongation (7) du support d'éléments constructifs (2) respectivement opposées aux

éléments constructifs (3).

Fig.1

EP 0 161 434 B1

# Fig.2

# Fig.3

# Fig.4